Europäisches Patentamt

European Patent Office

Office européen des brevets

(11) Veröffentlichungsnummer: **0 139 073**
**A2**

## (12) EUROPÄISCHE PATENTANMELDUNG

(21) Anmeldenummer: **84103707.0**

(22) Anmeldetag: **04.04.84**

(51) Int. Cl.⁴: **H 03 M 1/30**

(30) Priorität: **20.10.83 DE 3338108**

(43) Veröffentlichungstag der Anmeldung:
**02.05.85 Patentblatt 85/18**

(84) Benannte Vertragsstaaten:
**AT CH DE FR GB LI NL**

(71) Anmelder: **Wolff, Robert**
**Im Kiesacker 12**
**D-5446 Engeln(DE)**

(72) Erfinder: **Wolff, Robert**
**Im Kiesacker 12**
**D-5446 Engeln(DE)**

(74) Vertreter: **Peerbooms, Rudolf, Dipl.-Phys.**
**Postfach 200 208 Dickmannstrasse 45C**
**D-5600 Wuppertal 2(DE)**

(54) Digitale Messvorrichtung für drehwinkelabhängige Grössen.

(57) Eine digitale Meßvorrichtung für drehwinkelabhängige Größen mit nachgeschalteter Ziffernanzeige besitzt als Aufnehmer für die Drehbewegung einen kapazitiven Sensor (3) in Form von zwei winkelversetzt arbeitenden, jeweils winkelabhängig veränderlichen Kondensatoren (4, 5), wobei beide Kondensatoren (4, 5) mit dem Drehwinkel periodisch zu- und abnehmende Kapazitätswerte (38, 40) haben und wobei für die Auswertung durch ständigen Vergleich der Kapazitätswerte (38, 40) der beiden veränderlichen Kondensatoren (4, 5) mit dem Kapazitätswert (39) eines feststehenden Referenzkondensators (6) unter Beachtung der aus dem Winkelversatz ableitbaren Drehrichtung Impulse für einen addierend und subtrahierend arbeitenden elektronischen Zähler (16) gebildet werden.

FIG.1

Patentanwalt

)ipl.-Phys. Rudolf Peerbooms

Dickmannstraße 45c · Ruf (02 02) 55 61 47

5600 Wuppertal-Barmen

0139073

3829/EPÜ/N

Patentanmeldung

Anmelder : Robert Wolff

5446 Engeln

Digitale Meßvorrichtung für drehwinkelabhängige Größen

Die Erfindung betrifft eine digitale Meßvorrichtung für drehwinkelabhängige Größen mit nachgeschalteter Ziffernanzeige.

Zur Messung von drehwinkelabhängigen Größen ist eine Vielzahl von analog und digital arbeitenden Einrichtungen bekannt. Mit der fortschreitenden Entwicklung der Digitaltechnik haben sich insbesondere opto-elektronische Verfahren herausgebildet, bei denen ein optisch auswertbarer Strichmaßstab oder Sektormaßkreis opto-elektronisch abgetastet wird. Die Anzahl der durchlaufenden Hell-Dunkel-Grenzen oder Hell-Dunkel-Felder wird dabei gezählt. Das über eine Ziffernanzeige ausgegebene Zählergebnis ist dann ein Maß für den von einer gegebenen Nullstellung des Zählers aus zurückgelegten Winkel.

Nachteilig bei den bekannten opto-elektronischen Einrichtungen zur Winkelmessung sind die relativ hohen Kosten für die Herstellung der Strichmaßstäbe bzw. Sektormaßkreise und für die opto-elektronische Abtastung, was insbesondere für komplexere Meßeinrichtungen gilt, die neben dem Drehwinkel auch die Drehrichtung erfassen können. Der Einsatz derartiger Meßeinrichtungen beschränkt sich daher im allgemeinen auf Sonderzwecke, d. h. ein serienmäßiger Einbau in Heimwerkergeräte, Haushaltsgeräte od. dgl. kommt kaum in Frage. Zudem ist ihr Stromverbrauch so hoch, daß sie über längere Zeiträume hinweg nur mit Neztanschluß betrieben werden können.

Der Erfindung liegt die Aufgabe zugrunde, eine digitale Meßvorrichtung für drehwinkelabhängige Größen zu schaffen, die kostengünstig und außerdem unanfällig gegenüber äußeren Störeinflüssen ist und nur einen geringen Strombedarf hat.

Zur Lösung dieser Aufgabe ist erfindungsgemäß vorgesehen, daß als Aufnehmer für die Drehbewegung ein kapazitiver Sensor in Form von zwei winkelversetzt arbeitenden, jeweils winkelabhängig veränderlichen Kondensatoren verwendet wird, wobei beide Kondensatoren mit dem Drehwinkel periodisch zu- und abnehmende Kapazitätswerte haben und wobei für die Auswertung durch ständigen Vergleich der Kapazitätswerte der beiden veränderlichen Kondensatoren mit dem Kapazitätswert eines feststehenden Referenzkondensators unter Beachtung der aus dem Winkelversatz ableitbaren Drehrichtung Impulse für einen addierend und subtrahierend arbeitenden elektronischen Zähler gebildet werden. Kapazitive Sensoren lassen sich wesentlich kostengünstiger herstellen als Strichmaßstäbe und zugeordnete opto-elektronische Abtastvorrichtungen. Besonders vorteilhaft ist dabei der Einsatz von Kondensatoren, deren Kapazitätswerte mit dem Drehwinkel periodisch zu- und abnehmen. Infolge des etwa sinusförmigen Verlaufes der Kapazitätswerte lassen sich damit durch ständigen Vergleich mit einem feststehenden Referenzkondensator neben den Minima und Maxima auch Mittelwerte feststellen, so daß durch den einfachen Einbau eines zweiten, winkelversetzt angeordneten veränderlichen Kondensators die Drehrichtung festgestellt werden kann. Die dabei anfallenden Kapazitätswerte sind in einfacher Weise meß-, vergleich- und auswertbar.

Nach einer bevorzugten Ausführungsform kann der kapazitive Sensor eine Statorplatte und eine gegenüberliegende, die zu erfassende Drehbewegung mitausführende Rotorplatte aufweisen, können Stator- und Rotorplatte mit den Referenzkondensator bildenden, über den Umfang geschlossenen Ladungsflächen und mit Gruppen über den Umfang verteilten, die beiden veränderlichen Kondensatoren bildenden Ladungssektoren versehen sein,

deren Kapazitätswerte bei jeder Drehung von Sektor zu Sektor periodisch um den Kapazitätswert des Referenzkondensators pendeln. Ein Plattenkondensator mit einer Stator- und einer Rotorplatte, die mit Ladungssektoren versehen sind, stellt eine besonders einfache und kostengünstige Lösung für einen winkelabhängig veränderlichen Kondensator dar. Die Anordnung der beiden veränderlichen Kondensatoren und auch des feststehenden Referenzkondensators auf einem einzigen Plattenkondensator führt dabei zu einer weiteren Vereinfachung des Herstellungsverfahrens der Meßvorrichtung und hat insbesondere den Vorteil, daß äußere Störeinflüsse, wie z. B. axiale Verschiebungen der Kondensatorplatte oder Temperatur- oder Feuchtigkeitsveränderungen, alle drei Kondensatoren in gleicher Weise betreffen. Derartige Störfaktoren, die gerade bei Heimwerker- oder Haushaltsgeräten leicht auftreten können, wirken sich daher nicht mehr negativ auf das Gesamtmeßergebnis aus.

Der Erfindung zufolge kann die Statorplatte mit einer zentralen, kreisförmigen Ladungsfläche für den Referenzkondensator versehen sein, welche von zwei Gruppen strahlenförmig verteilter, gruppenweise zusammengeschalteter Ladungskondensatoren umgeben ist, und kann die Rotorplatte eine etwa gleich große zentrale, kreisförmige Ladungsfläche besitzen, an die eine Vielzahl strahlenförmig angeordneter Ladungssektoren elektrisch angeschlossen sind. Sowohl auf der Stator- als auch auf der Rotorplatte sind damit die Ladungsflächen in klarer, fertigungsgerechter Weise angeordnet. An der Statorplatte können bei dieser Aufteilung drei Ausgänge zur Erfassung der verschiedenen Kapazitätswerte vorgesehen sein, während für die Rotorplatte nur eine einzige, zentrale Zuleitung benötigt wird.

In weiterer Ausgestaltung der Erfindung kann vorgesehen werden, daß die Ladungssektoren von Stator- und Rotorplatte und die Leersektoren der Rotorplatte jeweils etwa gleiche Winkelbreite besitzen und daß auf der Statorplatte die aufeinanderfolgenden Leersektoren der beiden veränderlichen Kondensatoren Winkelabstände aufweisen, die jeweils zwischen halber und anderthalber Winkelbreite der anderen Sektoren abwechseln. Diese Zuordnung von Ladungs- und Leersektoren führt zu Meßsignalen, die sich mit Hilfe von üblichen elektronischen Logikschaltelementen auswerten lassen.

Der Erfindung zufolge kann zur Anzeige des aktuellen Zählerstandes eine mehrstellige Ziffernanzeige, insbesondere eine LED- oder LCD-Segmentanzeige verwendet werden. Derartige Ziffernanzeigen sind sehr kostengünstig und eignen sich in gleicher Weise wie der kapazitive Sensor für einen serienmäßigen Einbau in Heimwerker-, Haushaltsgeräten oder dgl.

Nach einer bevorzugten Ausführungsform der Erfindung können Stator- und Rotorplatte gedruckte Leiterplatten sein. Die Stator- und Rotorplatten mit ihren verschiedenen Ladungsflächenmustern lassen sich mit dieser Technik einfach und kostengünstig in industriellem Maßstab herstellen. Ein mög - licher Nachteil von gedruckten Leiterplatten, nämlich das Verziehen durch Feuchtigkeits- und Temperatureinflüsse, können sich nicht negativ auswirken, wenn alle drei Kondensatoren auf einem einzigen Plattenkondensator angeordnet sind, d. h. auch mit diesem einfachen Fertigungsverfahren kann eine hohe Meßpräzision erreicht werden.

In weiterer Ausgestaltung der Erfindung können die elektronischen Schaltungen für die Messung der Kapazitätswerte, für deren Vergleich, für die Auswertung, für den Zähler und für die Ansteuerung der Ziffernanzeigen in wenigen oder in einem integrierten Schaltkreis vereinigt sein. Damit ergibt sich insgesamt eine sehr platzsparende Meßvorrichtung, die ohne Probleme in die verschiedensten Geräte eingebaut werden kann.

Nach einer weiteren Ausführungsform der Erfindung kann eine Reset-Vorrichtung vorgesehen sein, mit der der Zähler bei jeder beliebigen Stellung des Sensors auf Null gestellt werden kann. Durch derartige Reset-Vorrichtungen werden die praktischen Einsatzmöglichkeiten der Meßvorrichtung wesentlich erweitert.

Die Rotorplatte kann mit dem drehenden Teil eines mechanischen Weg/Drehwinkel-Wandlers gekoppelt sein. Die Meßeinrichtung nach der Erfindung kann damit auch für lineare Wegmessungen, z. B. die Vorschubmessung bei Werkzeugmaschinen, eingesetzt werden. Als mechanische Weg/Drehwinkel-Wandler sind z. B. eine Kombination aus Zahnstange und Ritzel oder Reibfläche und Reibrad denkbar, die nur einen geringen Fertigungsaufwand erfordern und damit der Meßvorrichtung nach der Erfindung angepaßt sind.

Der Erfindung zufolge kann die Rotorplatte über ein Unter- oder Übersetzungsgetriebe mit der zu erfassenden Drehbewegung gekoppelt sein. Durch die Zwischenschaltung von Getrieben kann die Meßvorrichtung nach der Erfindung praktisch für jeden denkbaren Drehzahlbereich und jeden gewünschten Auflösungsgrad eingesetzt werden, ohne daß die Meßgenauigkeit beeinträchtigt wird.

Die Erfindung wird im folgenden anhand der Zeichnung näher beschrieben. In der Zeichnung zeigen :

Fig. 1 ein Blockschaltbild einer Meßvorrichtung für drehwinkelabhängige Größen mit Ziffernanzeige,

Fig. 2 eine Rotorplatte eines kapazitiven Sensors,

Fig. 3 die Statorplatte des kapazitiven Sensors,

Fig. 4 ein Diagramm der Kapazitätswerte des Sensors,

Fig. 5 die aus den Kapazitätswerten gebildeten Meßsignale,

Fig. 6 eine Tabelle zur Auswertung der Signale und

Fig. 7 eine Logikschaltung zur Tabelle nach Fig. 6.

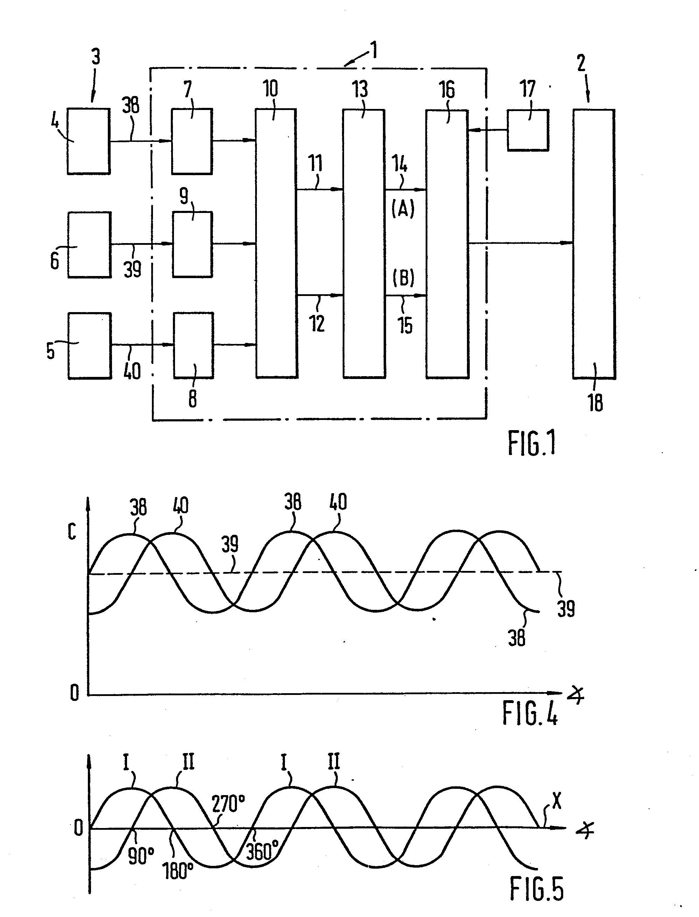

Fig. 1 zeigt eine digitale Meßvorrichtung für drehwinkelabhängige Größen mit einem integrierten Auswertschaltkreis 1, mit nachgeschalteter Ziffernanzeige 2 und mit einem Aufnehmer in Form eines kapazitiven Sensors 3. Der Sensor 3 besteht aus zwei winkelabhängig veränderlichen Kondensatoren 4, 5 sowie einem feststehenden Referenzkondensator 6. Die jeweiligen Kapazitätswerte der Kondensatoren 4, 5, 6 werden ständig über Kapazitätsmeßzellen 7, 8, 9 erfaßt und die Meßwerte bzw. ihnen entsprechende Signale einem Vergleicher 10 zugeführt. Im Vergleicher 10 wird für jeden der beiden veränderlichen Kondensatoren 4, 5 ein Differenzwert 11, 12 gegenüber dem Referenzkondensator 6 gebildet. Diese beiden Differenzwerte 11, 12 werden einem Decoder 13 zugeführt, der die Differenzwerte 11, 12 im Hinblick auf die Drehrichtung und das Fortschreiten der Drehbewegung auswertet und in entsprechende digitale Signale 14, 15 umsetzt. Dem Signal 14 entspricht dabei z. B. eine positive Drehrichtung, dem Signal 15 eine negative Drehrichtung. Die beiden Signale 14, 15 werden als addierende bzw. subtrahierende Impulse auf einen elektronischen Zähler 16 gegeben. Der Zähler 16 kann durch eine Reset-Vorrichtung 17 bei jedem Zählerstand auf Null zurückgestellt werden. Der jeweils aktuelle Zählerstand wird auf der Ziffernanzeige 2 angezeigt, die z. B. als LED- oder LCD-Segmentanzeige 18 ausgebildet sein kann. Die Meßzellen 7, 8, 9, der Vergleicher 10, der Decoder 13 sowie der Zähler 16 können zu dem gemeinsamen integrierten Schaltkreis 1 zusammengefaßt sein.

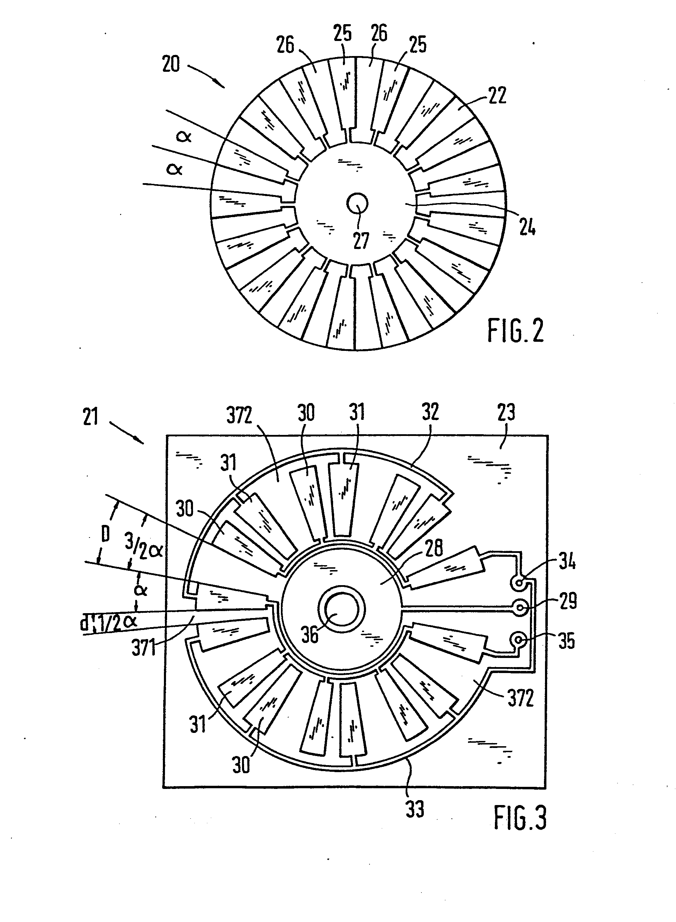

Die Fig. 2 und 3 zeigen eine die zu erfassende Drehbewegung mitausführende Rotorplatte 20 sowie eine Statorplatte 21, welche als gedruckte Leiterplatten 22, 23 ausgebildet sind. Die Rotorplatte 20 weist eine zentrale, kreisförmige Ladungsfläche 24 auf, welche eine Seite des Referenzkondensators 6 bildet. Im Außenbereich sind daran eine Vielzahl von strahlenförmig angeordneten Ladungssektoren 25 angeschlossen, die sich jeweils mit Leersektoren 26 etwa gleicher Winkelbreite $\alpha$ abwechseln. Die Rotorplatte 20 weist in ihrer Mitte eine Bohrung 27 auf, in die eine nicht gezeigte Welle zur Kopplung der zu messenden Drehbewegung eingeführt werden kann. Die Statorplatte 21 ist genau wie die Rotorplatte 20 mit einer zentralen, kreisförmigen Ladungsfläche 28 versehen, die zusammen mit der Ladungsfläche 24 den Referenzkondensator 6 bildet. Der Kapazitätswert des Referenzkondensators 6 wird an dem Anschluß 29 abgegriffen. Die Statorplatte 21 ist in ihrem Außenbereich mit zwei Gruppen strahlenförmig verteilter Ladungssektoren 30, 31 versehen, die über Leiter 32, 33 jeweils gruppenweise zusammengeschaltet sind. Die Ladungssektoren 30, 31 bilden zusammen mit den Ladungssektoren 25 der Rotorplatte die beiden veränderlichen Kondensatoren 4, 5, deren Kapazitätswerte an den Anschlußpunkten 34, 35 abgegriffen werden. Auch die Statorplatte 21 weist eine zentrale Bohrung 36 auf, in der die Welle der Rotorplatte gelagert werden kann. Zwischen den abwechselnd aufeinanderfolgenden Ladungssektoren 30, 31 befinden sich auf der Statorplatte 21 Leersektoren 371 und 372, deren Winkelabstände d, D abwechselnd etwa die Hälfte $\alpha/2$ oder das Anderthalbfache $3/2\alpha$ der Winkelbreite $\alpha$ der übrigen Sektoren 25, 26, 30, 31 betragen.

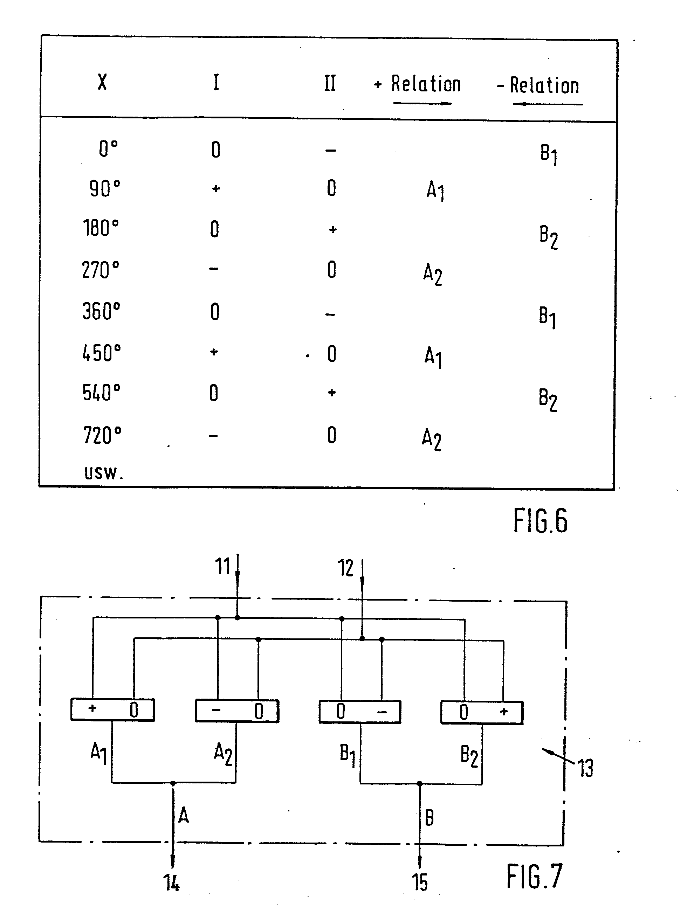

Bei der beschriebenen Anordnung der Ladungssektoren 25, 30, 31, Leersektoren 26, 371, 372 und Ladungsflächen 24, 28 ergeben sich bei einer Drehung der Rotorplatte 20 gegenüber der Statorplatte 21 z. B. für den ersten veränderlichen Kondensator 4 periodisch zu- und abnehmende Kapazitätswerte 38, wie sie in Fig. 4 in Abhängigkeit vom Winkel qualitativ aufgetragen sind. Die Ladungssektoren 30, 25 sind dabei im Verhältnis zu den Ladungsflächen 24, 28 des Referenzkondensators 6 derart bemessen, daß sie um den Kapazitätswert 39 des feststehenden Kondensators 6 pendeln. Die Kapazitätswerte 40 des zweiten veränderlichen Kondensators 5 pendeln in gleicher Weise um den Kapazitätswert 39 des konstanten Referenzkondensators 6, wobei aber die Kapazitätswerte 40 gegenüber den Kapazitätswerten 38 des ersten veränderlichen Kondensators 4 um etwa 90° nacheilen, was sich aus der unterschiedlichen Bemessung der Leersektoren 26 und 371, 372 ergibt.

Wird in dem Vergleicher 10 die Differenz zwischen den veränderlichen Kondensatorwerten 38, 40 und dem festen Kondensatorwert 39 gebildet, so entstehen die in Fig. 5 gezeigten Signalkurven I und II, die den Differenzwerten 11, 12 in Fig. 1 entsprechen. Die Signalkurven I und II pendeln periodisch um die Nullinie 41.

Fig. 6 zeigt tabellarisch die Relationen zwischen den beiden Signalkurven I und II in $90^{\circ}$-Schritten der Periodizität dieser Kurven I und II. Bei $90^{\circ}$, $270^{\circ}$, $450^{\circ}$ usw. zeigt die Kurve I ein Maximum $A_1$ oder Minimum $A_2$ - bzw. bei Inversion des letzteren alle $180^{\circ}$ ein Maximum - auf, während die Signalkurve II jeweils gerade durch Null verläuft. Diese Bedingungen werden in einer Logikschaltung gemäß Fig. 7 erfaßt, die vier UND-Glieder entsprechend den vier unterschiedlichen Relationen $A_1$, $A_2$, $B_1$ und $B_2$ aufweist. Bei Erfüllung der Relationen $A_1$ und $A_2$ wird jeweils ein Impulssignal A über 14 an den addierenden Eingang und im Falle von $B_1$ und $B_2$ über 15 ein Impulssignal B an den subtrahierenden Eingang des Zählers 16 geliefert, so daß die Meßanzeige richtungsabhängig zählt. Bei einer Umdrehung der Rotorplatte 20 mit n Ladungssektoren fällt jedes Signal A und B jeweils 2n-mal an, so daß sich eine hohe Auflösung erreichen läßt.

Patentanwalt

ɒl.-Phys. Rudolf Peerbooms

Dickmannstraße 45c · Ruf (02 02) 55 61 47
5600 Wuppertal-Barmen

0139073

- 13 -

3829/EPÜ/N

Patentansprüche

1. Digitale Meßvorrichtung für drehwinkelabhängige Größen mit nachgeschalteter Ziffernanzeige, dadurch gekennzeichnet, daß als Aufnehmer für die Drehbewegung ein kapazitiver Sensor (3) in Form von zwei winkelversetzt arbeitenden, jeweils winkelabhängig veränderlichen Kondensatoren (4, 5) verwendet wird, wobei beide Kondensatoren (4, 5) mit dem Drehwinkel periodisch zu- und abnehmende Kapazitätswerte (38, 40) haben und wobei für die Auswertung durch ständigen Vergleich der Kapazitätswerte der beiden veränderlichen Kondensatoren (4, 5) mit dem Kapazitätswert (39) eines feststehenden Referenzkondensators (6) unter Beachtung der aus dem Winkelversatz ableitbaren Drehrichtung Impulse (A, B) für einen addierend und subtrahierend arbeitenden elektronischen Zähler (16) gebildet werden.

2. Meßvorrichtung nach Anspruch 1, dadurch gekennzeichnet, daß der kapazitive Sensor (3) eine Statorplatte (21) und eine gegenüberliegende, die zu erfassende Drehbewegung mitausführende Rotorplatte (20) aufweist, daß Stator- und Rotorplatte (21, 20) mit den Referenzkondensator (6) bildenden, über den Umfang geschlossenen Ladungsflächen (28, 24) und mit Gruppen von über den Umfang verteilten, die beiden veränderlichen Kondensatoren 4, 5 bildenden Ladungssektoren (30, 31 und 25) versehen sind, deren (4, 5) Kapazitätswerte bei jeder Drehung von Sektor zu Sektor sich periodisch ändern, z. B. um den Kapazitätswert (39) des Referenzkondensators (6) pendeln.

3. Meßvorrichtung nach Anspruch 2, dadurch gekennzeichnet, daß die Statorplatte (21) mit einer zentralen, kreisförmigen Ladungsfläche (28) für den Referenzkondensator (6) versehen ist, welche von zwei Gruppen strahlenförmig verteilter, gruppenweise zusamengeschalteter Ladungssektoren (30, 31) umgeben ist, und daß die Rotorplatte (20) eine etwa gleich große zentrale, kreisförmige Ladungsfläche (24) besitzt, an die eine Vielzahl strahlenförmig angeordneter Ladungssektoren (25) elektrisch angeschlossen ist.

4. Meßvorrichtung nach Anspruch 3, dadurch gekennzeichnet, daß die Ladungssektoren (30, 31 und 25) von Stator- und Rotorplatte (21, 20) und die Leersektoren (26) der Rotorplatte (20) jeweils etwa gleiche Winkelbreite ($\alpha$) besitzen und daß auf der Statorplatte (21) die aufeinanderfolgenden Leersektoren (371, 372) der beiden veränderlichen Kondensatoren (4, 5) Winkelabstände (d, D) aufweisen, die jeweils zwischen halber und anderthalber Winkelbreite ($\alpha$) der anderen Sektoren (30, 31, 25) abwechseln.

5. Meßvorrichtung nach einem der Ansprüche 1 bis 4, dadurch gekennzeichnet, daß zur Anzeige des aktuellen Zählerstandes eine mehrstellige Ziffernanzeige (18), insbesondere eine LED- oder LCD-Segmentanzeige verwendet wird.

6. Meßvorrichtung nach einem der Ansprüche 1 bis 5, dadurch gekennzeichnet, daß Stator- und Rotorplatte (21, 20) gedruckte Leiterplatten sind.

7. Meßvorrichtung nach einem der Ansprüche 1 bis 6, dadurch gekennzeichnet, daß die elektronischen Schaltungen für die Messung der Kapazitätswerte, für deren Vergleich, für die Auswertung, für den Zähler und für die Ansteuerung der Ziffernanzeigen in wenigen oder in einem integrierten Schaltkreis (1) vereinigt sind.

8. Meßvorrichtung nach einem der Ansprüche 1 bis 7, dadurch gekennzeichnet, daß der Zähler (18) bei jeder beliebigen Stellung des Sensors (3) auf Null stellbar ist.

9.  Meßvorrichtung nach einem der Ansprüche 1 bis 8, dadurch gekennzeichnet, daß die Rotorplatte (20) mit dem drehenden Teil eines mechanischen Weg/Drehwinkel-Wandlers gekoppelt ist.

10. Meßvorrichtung nach einem der Ansprüche 1 bis 8 oder nach Anspruch 9, dadurch gekennzeichnet, daß die Rotorplatte (20) über ein Unter- oder Übersetzungsgetriebe mit der zu erfassenden Drehbewegung gekoppelt ist.

FIG.1

FIG.4

FIG.5

FIG.2

FIG.3

0139073

| X | I | II | + Relation → | − Relation ← |
|---|---|---|---|---|
| 0° | 0 | − | | $B_1$ |
| 90° | + | 0 | $A_1$ | |
| 180° | 0 | + | | $B_2$ |
| 270° | − | 0 | $A_2$ | |
| 360° | 0 | − | | $B_1$ |
| 450° | + | · 0 | $A_1$ | |
| 540° | 0 | + | | $B_2$ |
| 720° | − | 0 | $A_2$ | |
| USW. | | | | |

FIG.6

FIG.7